# EUROPEAN PATENT APPLICATION

(11) **EP 1 160 077 A2**
(43) Date of publication of application: **05.12.2001**
(21) Application number: 01113026.7
(22) Date of filing: 28.05.2001
(51) Int. Cl.: B32B 27/32, B32B 15/08, H05K 1/00

(54) **Low loss material for the manufacture of PCB'S and antenna boards and a method for producing same**

(30) Priority: 26.05.2000 IL 13638600; 22.06.2000 US 599173; 17.05.2001 US 859933
(71) Applicant: MTI Technology & Engineering (1993) Ltd., Rosh Ha'ayin 78101 (IL)
(72) Inventor: Ostrovsky, Valery, Ariel (IL)
(74) Representative: VOSSIUS & PARTNER

(57) **Abstract**

A method of manufacturing a low loss printed circuit board material including the steps of: providing a substrate comprising at least one layer of cross-linked polyethylene, providing a conducting foil, bringing a surface of the foil together with a surface of the substrate, casting a bonding layer of molten polyethylene between the surfaces, laminating the foil onto the substrate and cross-linking the bonding layer.

## Description

The present invention relates to a low loss material for the manufacture of PCBs and antenna boards, and a method for producing the same and more particularly but not exclusively to materials that are low loss at radio and microwave frequencies.

Electromagnetic waves in the range 1 to 40GHz when propagating through transmission lines on a PC Board generally give rise to dielectric losses in surrounding material. Thus, material that is used to make printed circuit boards, antenna boards etc, for use with microwave circuitry in particular, has to be chosen carefully. If not, the circuitry will be prone to losses and the efficiency will be low.

Furthermore, any material that is used in a printed circuit board has to be able to withstand soldering temperatures, as components are frequently soldered onto the board.

In addition, the conductor paths are generally printed onto the board using a process of etching into a conducting surface to remove unwanted conductor. The material used as a substrate in a printed circuit board has to be able to withstand the etching and soldering processes.

Typical substances used to date for the substrate include Teflon® glass, polyester-glass, and pure Teflon®.

Glass-impregnated plastics such as the polyester-glass material mentioned above, suffer from the following drawback. At high microwave frequencies, the resin molecules and glass fibers resonate within the substrate causing dissipation of energy. This effect causes high losses in the material and thus effectively limits its use to the lower part of the microwave spectrum.

Teflon-glass substrates are widely used across the microwave range due to their low dissipation factor. However they are expensive for a number of reasons. First Teflon is itself expensive. Secondly the manufacturing process involves a cyclic lamination process using hot presses. The process has a low yield.

As an alternative, polyester is cheaper but has a number of drawbacks. It has a dissipation factor, which is significantly larger than Teflon, 0.003 at frequencies above 1GHz and reaching to 0.005 at 10GHz. It also has a significant dissipation factor (DF) fluctuation over temperature within the range of 25°C to 80°C and this limits the possibilities for its application.

Another material that can be considered for the dielectric in a printed circuit board is polyethylene. A PCB board made of polyethylene is disclosed in US Patent No. 5,972,484. Polyethylene has very attractive dielectric properties but it has a low melting point (145°C), which is below the melting point of tin-lead solders. This means that it cannot be used in standard assembly processes. Furthermore polyethylene has a significant thermal expansion coefficient at solder temperatures. In addition, it shrinks when cooled after heating above 60 -70°C, for example after etching.

When gluing the laminations, the high temperatures required when setting the glue can give rise to local softening of the polyethylene and cause it to creep, giving rise to variations in the thickness of the dielectric.

A further disadvantage with polyethylene is that heat absorbed by the polyethylene substrate when laminated with molten bonding materials causes high-tension strain between the foil and the plastic as a result of the different thermal contraction rates of the different layers. After the copper is etched away, the tension may be released and, since the conducting surface does not shrink, the laminate will distort. This effect results in warping of the material in those areas where the remaining copper (namely that which remains after etching) has the strength to resist shrinkage.

In addition, the bonding materials that are generally used in low temperature laminating procedures (modified epoxy, polyurethane etc.) may cause an increase in the dissipation factor of the resin system to 0.009 and above, even though the layers of bonding materials themselves may only be 2 to 6 microns thick.

In accordance with a first aspect of the present invention there is provided a method of manufacturing a low loss printed circuit board material comprising providing a substrate including at least one layer of cross-linked polyethylene, providing a conducting foil, bringing a surface of the foil together with a surface of the substrate, casting a bonding layer of molten polyethylene between the surfaces, laminating the foil onto the substrate, and cross-linking the bonding layer.

In one embodiment, the step of laminating is carried out as a continuous roll to roll process.

In a further embodiment, the step of cross-linking is carried out using a high-energy electron beam or gamma radiation, which is capable of penetrating the conducting foil to effectively cross-link the bonding layer.

A further embodiment comprises the step of using an electron beam or gamma radiation to cross-link the polyethylene substrate from non-cross-linked polyethylene prior to lamination.

In a yet further embodiment, the electron beam or gamma radiation is used at a dosage optimized to minimize shrinkage of the substrate.

In a yet further embodiment, the lamination process is carried out without applying pressure to the substrate.

In a yet further embodiment, the substrate has a thickness substantially in the range 0.1 - 2mm.

In a yet further embodiment, the bonding layer has a thickness substantially in the range 5 to 50 microns.

The printed circuit board may be laminated using roll-to-roll technology.

According to a second aspect of the present invention there is provided a printed circuit board material comprising a substrate and at least one conducting surface, wherein the substrate comprises at least one layer of cross-linked polyethylene, wherein the at least one layer is directly in contact with the conducting surface, wherein the substrate is a laminate comprising at least one further layer, and wherein the further layer is made of any one of a group of substances comprising cross-linked polyethylene, polycarbonate, polystyrene, polyester, Ultem® (Polyestherimide), Noryl® (Polyphenylene Ether), and Teflon® (Polytetraflouroethylene).

The printed circuit board preferably has a thickness lying substantially in a range of 0.05 to 15mm.

In a particularly preferred embodiment, the board has a thickness lying substantially in a range of 0.05 to 0.3mm.

In one embodiment, the polyethylene is high density grade polyethylene.

In a yet further embodiment, any one of the layers is plastic foam. The foam allows large thicknesses to be used, and thus can serve as a built-in spacer.

In a yet further embodiment, the at least one conductive layer is made of any of copper, aluminum, gold, silver, brass, and any one of the same vapor deposited onto a plastic substrate. The circuit board may also have a second conductive layer, which may be made of either the same conductive material or a different conductive material as appropriate.

In a yet further embodiment, the substrate has a thickness substantially in the range 0.05 - 15mm.

In a yet further embodiment, the bonding layer has a thickness substantially in the range 5 to 150 microns.

According to a third aspect of the present invention there is provided the use of cross-linked polyethylene as both a substrate and a bonding material layer for a low-loss printed circuit board material.

According to a fourth aspect of the present invention there is provided the use of cross-linked polyethylene as a layer in a substrate and as a bonding material layer for a low-loss printed circuit board material.

The material manufactured as detailed above may result in the production of rolls of undefined length of low loss printed circuit board material, thus permitting continuous etching and printing when processing the material into PCBs.

For a better understanding of the invention and to show how the same may be carried into effect, reference is now made, purely by way of example, to the accompanying drawings, in which:
Fig. 1 is a generalized cross-sectional diagram showing a laminated PCB material according to a first embodiment of the present invention;
Fig. 2 is a generalized cross-sectional diagram showing a laminated PCB material according to a second embodiment of the present invention;
Fig. 3A is a generalized flow diagram illustrating a step of preparing a pre-laminate layer in a method for manufacturing the laminated PCB material of Fig. 2;
Fig. 3B is a generalized flow diagram illustrating a step of preparing a laminated PCB material using the pre-laminates of Fig. 3A;
Fig. 4 is a generalized diagram showing a step in the manufacturing process of an embodiment of the present invention and
Fig. 5 is a generalized diagram showing a further step on the manufacturing process of an embodiment of the present invention.

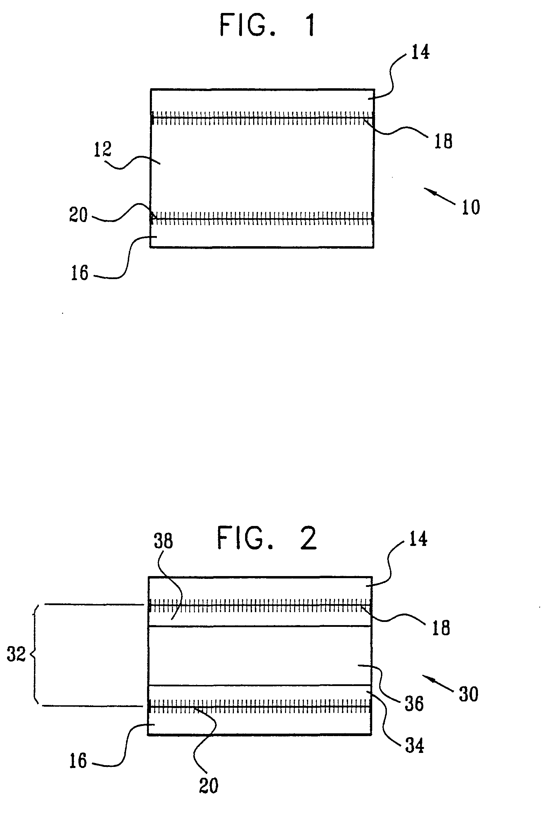

Reference is now made to Fig. 1 which is a generalized cross-sectional diagram showing a laminated PCB material 10 according to a first embodiment of the present invention. In Fig. 1, the laminated PCB material 10 comprises a substrate 12 of polyethylene having two layers of foil 14 and 16 laminated thereon at respective upper and lower surfaces thereof. The foils are attached using bonding layers of molten polyethylene 18 and 20 respectively, in a process that will be described in greater detail hereinbelow. The molten material bonds automatically to the polyethylene substrate and enters microcavities within the foil layers 14 and 16 providing high quality bonding of the substrate with the conduction layer.

The foil layers may be of any conducting materials, examples include copper aluminum, gold, silver, bronze or brass. The two foils 14 and 16 may each be of a respectively different conducting material. The foils may be a metal, vapor-deposited onto a plastic substrate.

The bonding layers are generally of anything between 5 and 150 microns in thickness, depending on the total thickness of the PCB material.

Following lamination, the bonding layers are preferably exposed to electron beam radiation and cross-linked so that the bonding layers are substantially dielectrically identical to the remainder of the substrate.

The substrate 12 of polyethylene is cross-linked prior to lamination by exposing it to radiation from an electron beam. This results in a substrate that has a melting temperature of 175°C -185°C, sufficiently high for it not to be effected by low temperature soldering. The substrate also has a dissipation factor of 0.001 or less for a frequency range of between 1 and 40GHz. In addition, cross-linking of the material adds to its mechanical strength. Furthermore, shrinkage is reduced considerably. Minor distortion is still present following etching of the foil layer as a result of the release of tension, however, if the molten bonding layer is introduced at a temperature of 145°C, then a maximum shrinkage of -0.3% is realized. This level of shrinkage is generally insignificant for most applications.

The cross-linked polyethylene has a dielectric constant (DK) of 2.32, which is similar to the Teflon glass laminates referred to above in the Background of the Invention.

An advantage of the present embodiment is that, because bonding is preferably carried out using the same material as the substrate, the overall properties of the substrate, in particular the dielectric properties, are unchanged as a result of bonding. No glues are applied in the lamination process

Reference is now made to Fig. 2 which is a generalized cross-sectional diagram showing a laminated PCB material 30 according to a second embodiment of the present invention. PCB material 30 comprises a substrate 32 which itself is laminated from three layers of polyethylene 34, 36 and 38. Layer 34 is cross-linked polyethylene sheet, as is layer 38, and layer 36, in the middle, is preferably a foam. Alternatively, layer 36 may be made of other substances such as polycarbonate, polystyrene, Ultem® (Polyestherimide), Noryl® (Polyphenylene Ether), Teflon® (Polytetraflouroethylene) and others. The use of such substances may help in diminishing shrinkage and may alter the dielectric properties of the substance. As a further alternative, layer 36 may simply be a third layer of cross-linked polyethylene.

Again, as in the embodiment of Fig. 1, foil layers 14 and 16 are bonded to either surface using bonding layers 18 and 20.

The use of foam allows materials of unlimited thickness and thus permits the production of a circuit-board material having a built-in spacer. This can usefully simplify the production of large numbers of microwave and related products where spacings between conducting elements and groundplanes etc are critical.

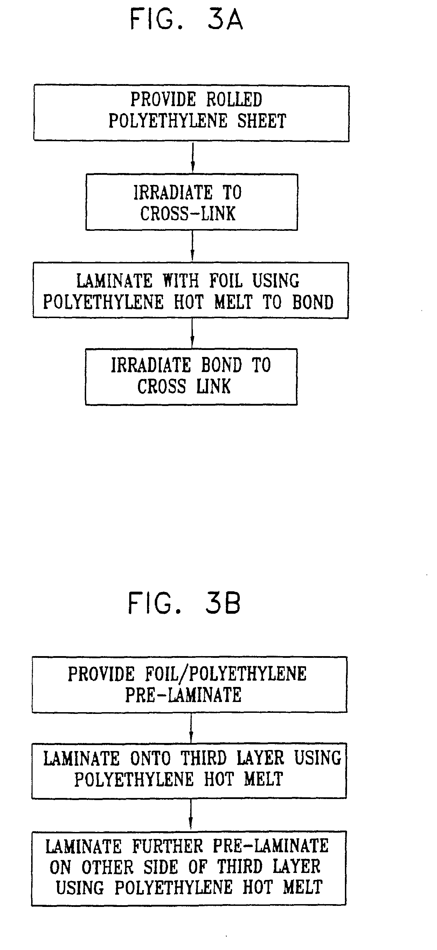

Reference is now made to Fig. 3A, which is a generalized flow diagram indicating a preferred method for preparing a pre-laminate for manufacturing the laminated PCB of Fig. 2.

A first step in the manufacture of the PCB material is to provide rolls of polyethylene sheet. The sheet is exposed to radiation, preferably from an electron beam, or gamma radiation whose energy is sufficient to cause cross-linking. Preferably the energy level (radiation dose) is optimized to cause cross-linking levels needed to minimize shrinkage at etching temperatures.

A PCB material sheet roll is then laminated together in a continuous process with a roll of metal foil to produce a pre-laminate. The lamination process is a process of attaching together two sheets taken directly off two different rolls at high speed. The process is carried out continuously until one of the rolls is finished. A molten layer of non cross-linked polyethylene is cast in from an extrusion die'between the substrate and the foil, which bonds naturally with the substrate itself and enters the micropores of the foil, thereby producing an effective bond between the substrate and the foil.

The polyethylene substrate thickness is typically in the region of 0.1mm to approximately 2mm, depending on the application.

Once the substrate is prepared, the next stage (Fig. 3B) is to provide rolls of foil for the outer layers of the PCB material. Once again a continuous lamination process is used to laminate a layer of foil onto one surface of the substrate. Following lamination of a foil onto one surface, an identical process is carried out to laminate a foil onto the second surface.

Following lamination of the foil onto both surfaces, the bonding layers at the upper and lower surfaces of the PCB material are cross-linked by irradiating with a high energy electron beam which is able to penetrate through the foil.

The laminated materials are fabricated in rolls and are irradiated and laminated at speeds of tens of meters per minute. In general, a continuous process is cheaper per unit of final product than a cyclical process.

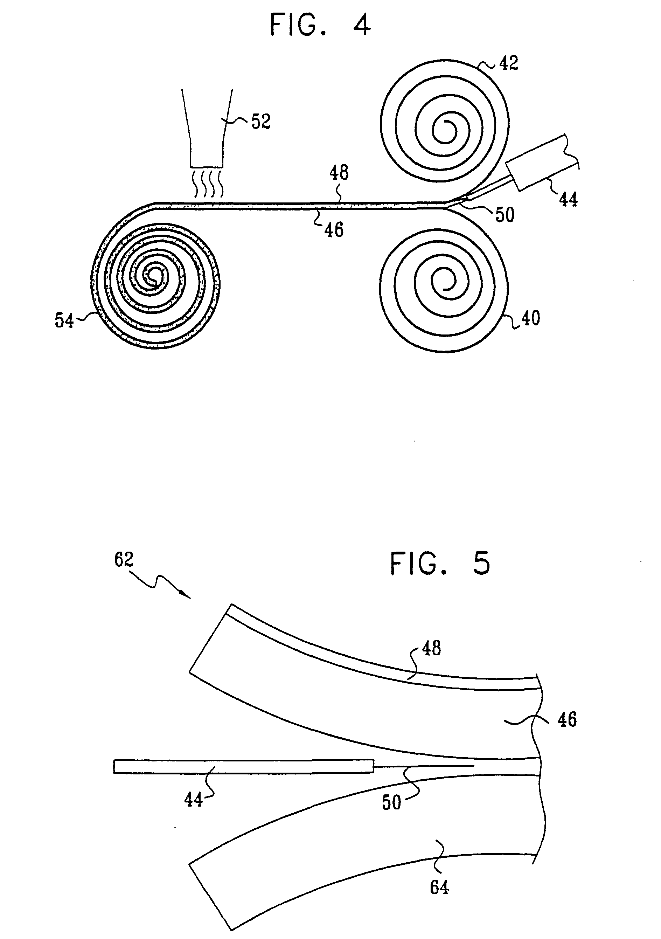

Reference is now made to Fig. 4, which is a generalized diagram showing a stage in a lamination process according to an embodiment of the present invention. A roll 40 of cross-linked polyethylene is placed opposite a roll 42 of foil, with an extrusion die 44 in between. Sheets of polyethylene 46 and foil 48 are pulled away from the rolls 40 and 42 to meet at the output of the extrusion die 44. Non-cross linked molten polyethylene 50 is extruded from the die 44 to form a bonding layer between the two sheets 46 and 48. The sheets then pass a source 52 of high energy electron beam radiation, which irradiates the bonding layer 50 through the foil sheet 48 to cross-link the bonding layer 50. The product, which forms a pre-laminate for the next stage, described with reference to Fig. 5, is then rolled into roll 54.

In an alternative embodiment, the bonding of the conducting layer to the substrate is carried out using high melting point polypropylene. This has a melting point of 170°C and thus no step of cross-linking the bonding layer is necessary.

In either embodiment, the use of a polymer melt to form the bond preferably does not require any pressure to be placed on the substrate during lamination. Therefore changes in thickness of the lamination can be considerably reduced if not avoided entirely.

Referring now to Fig. 5 there is shown a subsequent stage in the lamination process according to the embodiment of Fig. 4.

A pre-laminate 60, formed from copper 48 and cross-linked polyethylene 46 in the manufacturing step shown in Fig. 4, is used as an upper layer 62 for lamination with a further layer 64. The further layer 64 may comprise cross-linked polyethylene or any other of the materials discussed above with reference to layer 36 of Fig. 2. The layers are preferably laminated together using hot melt polyethylene 50 as before but in this phase the layer is not cross-linked.

Following this stage, a further layer of pre-laminate 60 is laminated to form a lower layer to form the board shown in Fig. 2.

An advantage of certain embodiments of the present invention is that the printed circuit board material can be manufactured in sheets or rolls of undefined length.

It is appreciated that various features of the invention which are, for clarity, described in the contexts of separate embodiments may also be provided in combination in a single embodiment. Conversely, various features of the invention which are, for brevity, described in the context of a single embodiment may also be provided separately or in any suitable subcombination.

In the claims that follow, the term printed circuit board is used. However the invention relates to any substrate for use in association with electronic components and in particular high frequency electronic components, and also includes for example antenna boards.

It will be appreciated by persons skilled in the art that the present invention is not limited to what has been particularly shown and described hereinabove. Rather, the scope of the present invention includes both combinations and subcombinations of the various features described hereinabove as well as variations and modifications thereof which would occur to persons skilled in the art upon reading the foregoing description and which are not in the prior art.

## Claims

1. A method of manufacturing a low loss printed circuit board material comprising the steps of:
providing a substrate comprising at least one layer of cross-linked polyethylene,
providing a conducting foil,
bringing a surface of the foil together with a surface of the substrate,
casting a bonding layer of molten polyethylene between the surfaces,
laminating the foil onto the substrate, and
cross-linking the bonding layer.

2. A method according to claim 1, wherein said step of laminating is carried out as a continuous roll to roll process.

3. A method according to claim 1 or 2, wherein said step of cross-linking is carried out using a high-energy electron beam or gamma radiation which is capable of penetrating said conducting foil to effectively cross-link said bonding layer.

4. A method according to claim 1, 2, or 3, comprising the step of using an electron beam or gamma radiation to cross-link said polyethylene substrate from non-cross-linked polyethylene prior to lamination.

5. A method according to claim 4, wherein said electron beam or gamma radiation is used at a dosage optimized to minimize shrinkage of said substrate.

6. A method according to claim 1, 2, 3, 4 or 5, wherein said lamination process is carried out without applying pressure to said substrate.

7. A method according to any one of claims 1 to 6, wherein the substrate has a thickness substantially in the range 0.1 - 2mm.

8. A method according to any one of claims 1 to 7, wherein the bonding layer has a thickness substantially in the range 5 to 50 microns.

9. A printed circuit board material producible according to the method of any one of claims 1 to 8.

10. A printed circuit board material according to claim 9, laminated using roll-to-roll technology.

11. A printed circuit board material comprising a substrate and at least one conducting surface, wherein the substrate comprises at least one layer of cross-linked polyethylene, wherein said at least one layer is directly in contact with said conducting surface, wherein said substrate is a laminate comprising at least one further layer, and wherein said further layer is made of any one of a group of substances comprising cross-linked polyethylene, polycarbonate, polystyrene, polyester, Ultem® (Polyestherimide), Noryl® (Polyphenylene Ether), and Teflon® (Polytetraflouroethylene).

12. A printed circuit board material according to claim 11, having a thickness lying substantially in a range of 0.05 to 15mm.

13. A printed circuit board material according to claim 11, having a thickness lying substantially in a range of 0.05 to 0.3mm.

14. A printed circuit board material according to claim 11, 12 or 13, wherein the polyethylene is high density grade polyethylene.

15. A printed circuit board material according to claim 11, 12, 13 or 14, wherein any one of said layers is plastic foam.

16. A printed circuit board material according to claim 15, wherein the foam is used as a spacer.

17. A material according to any one of claims 11 to 16, wherein said at least one conductive layer is made of any one of a group of materials comprising copper, aluminum, gold, silver, brass, and any one of the same vapor deposited onto a plastic substrate.

18. A printed circuit board material according to claim 17, having a second conductive layer and wherein said second conductive layer is made from a second one of said group of materials.

19. A printed circuit board material according to claim 17, having a second conductive layer and wherein said second conductive layer is made from the same one of said group of materials.

20. A material according to any one of claims 11 to 19, wherein the substrate has a thickness substantially in the range 0.05 - 15mm.

21. A material according to any one of claims 11 to 20, wherein the bonding layer has a thickness substantially in the range 5 to 150 microns.

22. The use of cross-linked polyethylene as both a substrate and a bonding material layer for a low-loss printed circuit board material.

23. The use of cross-linked polyethylene as a layer in a substrate and as a bonding material layer for a low-loss printed circuit board material.

24. The use according to claim 22 or 23, in the production of rolls of undefined length of low loss printed circuit board material to permit continuous etching and printing when processing the material into PCBs.
